# EUROPÄISCHE PATENTSCHRIFT

(11) **EP 1 132 945 B1**
(45) Veröffentlichungstag und Bekanntmachung des Hinweises auf die Patenterteilung: **10.09.2008**
(21) Anmeldenummer: 01105079.6
(22) Anmeldetag: 02.03.2001
(51) Int. Cl.: H01J 37/317, H01J 37/304, H01J 37/302

(54) **Verfahren und Vorrichtung zur Ausbildung eines gekrümmten Linienzuges auf einem strahlungsempfindlichen Resist**
Method and device for producing curved lines on an irradiation sensitive resist
Procédé et dispositif pour la production de lignes courbes sur un resist sensible au rayonnement

(30) Priorität: 08.03.2000 DE 10011201
(43) Veröffentlichungstag der Anmeldung: 12.09.2001
(73) Patentinhaber: Vistec Electron Beam GmbH, 07745 Jena (DE)
(72) Erfinder: Plontke, Rainer, Dr., 99441 Göttern (DE); Schubert, Andreas, 99510 Niederrossla (DE); Blume, Michael, 07749 Jena (DE); Stolberg, Ines, 07743 Jena (DE)
(74) Vertreter: Freitag, Joachim

(56) Entgegenhaltungen:
- KING O: "CURVED GRATING FABRICATION TECHNIQUES FOR SURFACE-EMITTING DISTRIBUTED FEEDBACK LASERS" JOURNAL OF VACUUM SCIENCE AND TECHNOLOGY: PART B, AVS / AIP, MELVILLE, NEW YORK, NY, US, Bd. 10, Nr. 6, 1. November 1992 (1992-11-01), Seiten 2974-2978, XP000332509 ISSN: 1071-1023
- KLEY E-B ET AL: "E-BEAM LITHOGRAPHY: A SUITABLE TECHNOLOGY FOR FABRICATION OF HIGH-ACCURACY 2D AND 3D SURFACE PROFILES" PROCEEDINGS OF THE SPIE, SPIE, BELLINGHAM, VA, US, Bd. 2640, 23. Oktober 1995 (1995-10-23), Seiten 71-80, XP009031977 ISSN: 0277-786X
- PATENT ABSTRACTS OF JAPAN Bd. 018, Nr. 008 (E-1486), 7. Januar 1994 (1994-01-07) -& JP 05 251318 A (JEOL LTD), 28. September 1993 (1993-09-28)
- SCHNABEL B ET AL: "FABRICATION AND APPLICATION OF SUBWAVELENGTH GRATINGS" PROCEEDINGS OF THE SPIE, SPIE, BELLINGHAM, VA, US, Bd. 3008, 10. Februar 1997 (1997-02-10), Seiten 233-241, XP009031976 ISSN: 0277-786X
- SCHLIEBE T: "Generation of Large Area Condenser Zone Plates with Smallest Zone Width Below 40 nm by Electron Beam Lithography" MICROELECTRONIC ENGINEERING, ELSEVIER PUBLISHERS BV., AMSTERDAM, NL, Bd. 41-42, März 1998 (1998-03), Seiten 465-468, XP004111758 ISSN: 0167-9317
- SCHNABEL B ET AL: "On the influence of the e-beam writer address grid on the optical quality of high-frequency gratings" MICROELECTRONIC ENGINEERING, ELSEVIER PUBLISHERS BV., AMSTERDAM, NL, Bd. 57-58, September 2001 (2001-09), Seiten 327-333, XP004302281 ISSN: 0167-9317

## Beschreibung

Die Erfindung bezieht sich auf das Gebiet der Elektronenstrahl-Lithographie und hier insbesondere auf ein Verfahren sowie eine elektronenstrahllithographische Vorrichtung zur Ausbildung eines gekrümmten Linienzuges auf einem mit einem strahlungsempfindlichen Resist beschichteten Substrat mit Hilfe eines Elektronenstrahls, wobei der Elektronenstrahl in Richtung der Koordinate Z auf die beschichtete Substratoberfläche gerichtet und das Substrat schrittweise in Richtung der Koordinaten X und/oder Y eines kartesischen Rasters verschoben wird, während der Elektronenstrahl mit vorgegebener effektiver Dosis auf den Resist einwirkt.

Bekannte Vorrichtungen zur Elektronenstrahl-Lithographie umfassen eine Strahlungsquelle zur Abgabe eines gebündelten Elektronenstrahles, der auf ein mit einem strahlungsempfindlichen Resist beschichtetes Substrat gerichtet ist. Das Substrat wird mit senkrecht zum Elektronenstrahl ausgerichteter, die Resistschicht tragender Oberfläche auf einen im kartesischen Raster verschiebbaren Tisch aufgelegt und dort gehalten. Durch vorgegebene Tischverschiebung oder elektromagnetische Ablenkung des Elektronenstrahles oder auch beides gleichzeitig, wobei der Auftreffort des Elektronestrahles definiert gegenüber der Substratoberfläche geändert wird, werden geometrische Strukturen oder Muster, insbesondere Linienzüge in den Resist geschrieben.

Dieses Prinzip der Relativbewegung zwischen dem Substrat und dem Elektronenstrahl durch Verschiebung des Substrattisches gegenüber einem zumindest näherungsweise stationären Elektronenstrahl ist beispielsweise aus Microelectronic Engineering (1995) 135-138 bekannt. Eine alternative Möglichkeit zur gezielten Veränderung des Auftreffortes an der Substratoberfläche besteht in der Ablenkung des Elektronenstrahls, beispielsweise mittels elektromagnetischer Ablenksysteme.

Da derartige Vorrichtungen zur Positionierung des Substrattisches bzw. des Elektronenstrahls in der Regel ein kartesisches Koordinatensystem mit den Koordinaten X,Y nutzen, erfolgt die Datenbeschreibung der an dem Substrat auszubildenden geometrischen Strukturen ebenfalls bevorzugt in kartesischen Koordinaten. Diese sind für die Beschreibung von Strukturen mit überwiegend rechteckiger oder trapezartiger Form, wie sie in der Mikroelektronik typischerweise verwendet werden, gut geeignet. Die hierbei zumeist auftretenden geraden Linienzüge können mit schrittweise gesteuerten Positioniereinrichtungen bei geringer Kantenrauhigkeit auf das Substrat übertragen werden.

Insbesondere bei der Belichtung von Substraten, die für optische Anwendungen gedacht sind, besteht jedoch ein großes Interesse daran, auch gekrümmte Linienzüge mit hoher Genauigkeit zu schreiben, um beispielsweise elliptische Gitter, zirkulare Gitter oder auch gekrümmte Wellenleiter herstellen zu können. Derartige Linienzüge lassen sich bei Verwendung eines kartesischen Rasters allenfalls mit der Genauigkeit der Einzelinkremente geeigneter Positioniereinrichtungen in deren Koordinaten X und Y approximieren. Wird die Einzelinkrementweite in bezug auf die Breite des gewünschten Linienzuges ausreichend klein gewählt, so ist die durch die schrittweise Approximation bedingte Kantenrauhigkeit bzw. Formabweichung des angenäherten Linienzuges von einem theoretisch idealen Linienzug zu vernachlässigen.

Die Ausbildung eines Linienzuges an dem Substrat erfolgt aufgrund der Tischverstellung in inkrementellen Schritten durch eine enge Aneinanderreihung einer Vielzahl von Bestrahlungspunkten. Zur Bestrahlung eines Punktes bleibt der Elektronenstrahl für eine kurze Verweildauer auf den betreffenden Punkt gerichtet, bis ein gewünschter Energieeintrag erreicht ist. Anschließend wird der nächste Punkt angesteuert und es wird in der gleichen Weise vorgegangen.

Dabei ist es nicht unbedingt notwendig, die Elektronenstrahlung zwischen unmittelbar aufeinander folgenden Punkten auszuschalten. Je nach Höhe des Energieeintrages an dem Auftreffort des Elektronenstrahls auf dem Resist ergibt sich ein kleinerer oder größerer belichteter Punkt" auf dem Resist.

Bei der Ausbildung von Linienzügen mit sehr geringer, jedoch möglichst gleichmäßiger Linienbreite ist es daher von großer Wichtigkeit, den entlang des Linienzuges in den elektronenempfindlichen Resist eingebrachten Energieeintrag, d.h. die effektive Dosis (Ladung pro Fläche) bzw. effektive Liniendosis (Ladung pro Länge), weitestgehend konstant zu halten. Die andernfalls auftretenden Breitenschwankungen an dem Linienzug lassen sich, im Unterschied zu der Kantenrauhigkeit, durch eine Verringerung der Einzelschritte bei der Positionierung des Substrates zu dem Elektronenstrahl nicht ausschalten.

Eine technische Lösung zur Vermeidung von Linienbreitenschwankungen ist in J. Vac. Sci. Technol. B 10(6), Nov/Dec 1992 (2974 - 2978) beschrieben.

Mittels einer in den Koordinaten X,Y schrittweise betriebenen Positioniereinrichtung sind sowohl achsparallele Einzelschritte möglich, bei denen lediglich eine Fortschaltung in einer der Koordinaten X oder Y um ein Einzelinkrement erfolgt, wie auch Einzelschritte, bei denen sowohl in der Koordinate X als auch in der Koordinate Y weitergeschaltet wird. Es ist ersichtlich, daß im letztgenannten Fall der Abstand zwischen dem Ausgangspunkt und dem Endpunkt des Einzelschrittes größer ist, als bei einem achsparallelen Einzelschritt. Sind die Einzelinkremente in den beiden Koordinaten X und Y gleich groß, so ergibt sich eine Längenzunahme um den Faktor √2.

Wird also nach jedem Einzelschritt ein gleicher Energieeintrag vorgenommen, so ergibt sich für einen achsparallelen Linienzug in der Koordinatenrichtung X oder Y eine höhere Liniendosis als für einen diagonalen Linienzug in Richtung einer unter einem Winkel von 45° gegen die Koordinate X bzw. Y geneigten Geraden. Dieser unterschiedliche Energieeintrag wirkt sich in einer Abweichung der Linienbreite aus. So weist der diagonale Linienzug eine geringere Breite auf als der achsparallele Linienzug.

Wird dagegen umgekehrt ein um den Faktor √2 erhöhter Energieeintrag fest vorgegeben, so ergibt sich bezogen auf die achsparallel zu erzeugende Gerade eine zu hohe Liniendosis, da die Bahnlänge kleiner ist als bei der geneigten Geraden. Eine quantitative Rechnung zeigt, daß im vorliegenden Betrachtungsfall die Abweichung bei einem Winkel von 22,5° am größten ist und etwa 8% beträgt. Theoretisch wäre es möglich, diese Abweichung zu vermindern, indem der Energieeintrag für eine Gerade winkelabhängig eingestellt wird. Allerdings wäre dies mit einem erheblich höheren Rechenaufwand verbunden.

Bei gekrümmten Linienzügen, insbesondere bei Kreislinien, ändert sich die Bahnneigung stetig. Eine gesonderte Berechnung des Energieeintrages nach jedem Einzelschritt würde zu einem enormen Anwachsen des Rechenaufwandes führen und deshalb die Arbeitsgeschwindigkeit beim Schreiben einer gekrümmten Linie drastisch vermindern. Diese Vorgehensweise der Bestimmung des exakten Energieeintrags in Abhängigkeit der aktuellen Neigung des Linienzuges nach jedem Einzelschritt ist daher im Hinblick auf eine effiziente Fertigung wenig befriedigend. Andererseits machen sich gerade bei zirkularen Gittern die aus der Approximation resultierenden Dosisschwankungen besonders deutlich bemerkbar, so daß ein Interesse daran besteht, hier Abhilfe zu schaffen.

Der Erfindung liegt daher die Aufgabe zugrunde, die bekannten Verfahren zur Elektronenstrahl-Lithographie derart weiterzubilden, daß die Ausbildung von gekrümmten Linienzügen mit gleichmäßiger Linienbreite bei geringem Rechenaufwand möglich ist.

Die Aufgabe wird erfindungsgemäß durch ein Verfahren gemäß den Merkmalen des Anspruches 1 gelöst.

Auf diese Weise wird ein dem Verlauf des Linienzuges weitestgehend angepaßter Energieeintrag in den Resist erreicht, so daß sich beliebig gekrümmte Linienzüge mit einer sehr gleichmäßigen Linienbreite herstellen lassen. Durch die Berücksichtigung mehrerer vorhergehender Einzelschritte werden bereits erfaßte oder berechnete Informationen über den Verlauf des Linienzuges zur Bestimmung des Energieeintrages nach dem zuletzt durchgeführten Positionierungseinzelschritt herangezogen. Der hierzu erforderliche Rechenaufwand ist in einem erheblichen Ausmaß geringer als die gesonderte Berechnung des theoretisch exakten Energieeintrags aus der Beschreibung des Verlaufs des Linienzuges im Zusammenhang mit der Durchführung eines Einzelschrittes. Diese Berücksichtigung der Vorgeschichte jeweils eines Einzelschrittes läßt sich quasi ohne Verringerung der Arbeitsgeschwindigkeit verwirklichen.

Das Grundprinzip des erfindungsgemäßen Verfahrens besteht darin, eine Anzahl von Kategorien von Einzelschritten zu definieren, denen jeweils ein bestimmter Korrekturfaktor zum Zwecke der Bestimmung des Energieeintrages bei einem später nachfolgenden Einzelschritt zugeordnet wird. Dabei ist es sinnvoll, die den Kategorien unterschiedlicher Einzelschritte zugeordneten Korrekturfaktoren entsprechend der jeweils kürzesten Weglänge zwischen dem Anfangspunkt und dem Endpunkt zu wichten und Einzelschritte mit gleicher Wichtung jeweils einer Kategorie zuzuordnen.

In einer bevorzugten Ausführung des Verfahrens werden lediglich zwei Kategorien von Einzelschritten verwendet, nämlich eine erste Kategorie A achsparalleler Einzelschritte in Form von Einzelinkrementen in Richtung der X-Koordinate **oder** der Y-Koordinate sowie eine zweite Kategorie B diagonaler Einzelschritte in Form jeweils eines Einzelinkrementes in der X- **und** Y-Koordinate.

Den Einzelschritten der Kategorie A wird ein Korrekturfaktor von 1 und denen der Kategorie B ein Korrekturfaktor von √2 zugeordnet. Die Bestimmung des Energieeintrages für einen nachfolgenden Einzelschritt erfolgt erfindungsgemäß in Abhängigkeit von einer Anzahl vorher zurückgelegter Einzelschritte in der Kategorie A und in der Kategorie B. Durch die Orientierung an den Einzelinkrementen in der X- und Y-Koordinate sowie die geringe Zahl unterschiedlicher Typen von Einzelschritten bleibt der Steuerungs- und Berechnungsaufwand bei der Anwendung des Verfahrens gering. Gleichwohl wird ein sehr gleichmäßiger Verlauf der effektiven Liniendosis und damit der Linienbreite entlang einer beliebig gekrümmten Bahnkurve unabhängig von deren Neigungswinkel erzielt.

Ein besonders geringer Rechenaufwand ergibt sich beispielsweise bei Betrachtung von acht unmittelbar vorangegangenen Einzelschritten und bei einer Bestimmung eines mittleren Korrekturfaktors Kₙ entsprechend der in Patentanspruch 3 angegebenen Zuordnungsvorschrift in Abhängigkeit der Anzahl der Einzelschritte in den Kategorien A und B.

Es ist jedoch ohne weiteres möglich, bei Bedarf die Anzahl der rückwirkend betrachteten Einzelschritte zu vermindern oder, zur weiteren Verbesserung der Genauigkeit, zu erhöhen. Allerdings steigt mit zunehmender Anzahl der zu betrachtenden Einzelschritte der Hardware- und Berechnungsaufwand an. Überdies können weit zurückliegende Einzelschritte zu einer Fehlbestimmung des mittleren Korrekturfaktors Kₙ führen. Die Betrachtung von acht vorhergehenden Einzelschritten hat sich unter Berücksichtigung dieser Problematik als besonders vorteilhaft erwiesen. Bevorzugt wird der Energieeintrag proportional zu dem errechneten mittleren Korrekturfaktor Kₙ vorgenommen.

Bei gleichbleibender Strahlungsleistung erfolgt die Einstellung des Energieeintrages über die Einwirkdauer des Elektronenstrahls für jeden Einzelschritt proportional zu dem Korrekturfaktor Kₙ. Diese Vorgehensweise hat den Vorteil, daß als Strahlungsquelle eine Feldemissionskathode verwendet werden kann, die sich durch eine im Stationärbetrieb außerordentlich gleichmäßige Strahlungsleistung auszeichnet. Die Einwirkdauer wird mit der Verweilzeit des Tisches nach einem Einzelschritt vorgegeben. Folglich ist das Zeitintervall, mit der der Tisch nach einem erfolgten Einzelschritt in seiner Stellung verharrt, proportional zu dem mittleren Korrekturfaktor Kₙ.

In einer alternativen Ausgestaltung des Verfahrens wird bei gleichbleibender Einwirkdauer bzw. konstanter Anhaltezeit der Energieeintrag durch eine Veränderung der Strahlungsleistung vorgenommen. Das hat den Vorteil, daß die Tischverschiebung mit gleichbleibenden Arbeitstakten verwirklicht werden kann. Bei Verwendung einer Feldemissionskathode als Strahlungsquelle ist es allerdings nicht sinnvoll, deren Strahlungsleistung während des Betriebes zu verändern, da die Anpassung der Strahlungsleistung an die Veränderung einer angelegten Spannung nur sehr langsam erfolgt. Vielmehr wird zur Beeinflussung des Energieeintrages der von der Strahlungsquelle abgegebene Elektronenstrahl nachfolgend geschwächt, beispielsweise unter Verwendung einer Luftspule. Insofern ist der erstgenannten Variante mit veränderlicher Anhaltezeit der Vorzug zu geben.

Die Aufgabe der Erfindung wird weiterhin gelöst mit einer Vorrichtung gemäß den Merkmalen des Anspruches 6.

Die erfindungsgemäße Vorrichtung ermöglicht die Anwendung des oben erläuterten Verfahrens zur Erzeugung eines beliebig gekrümmten Linienzuges bei einem dem Verlauf des Linienzuges weitestgehend angepaßten Energieeintrag in den Resist und damit einer gleichbleibenden Linienbreite.

Die Erfindung wird nachfolgend anhand eines in der Zeichnung dargestellten Ausführungsbeispiels näher erläutert. Die zugehörigen Zeichnungen zeigen in:
- Fig.1: ein Ausführungsbeispiel einer Vorrichtung zur Elektronenstrahl-Lithographie in schematischer Darstellung,
- Fig.2: ein Diagramm zur Veranschaulichung der möglichen Einzelschritte zum Verschieben eines Substrates mittels eines Tisches der Vorrichtung von Fig.1,
- Fig.3: einen Ablaufplan zur Bestimmung des Energieeintrages in das Substrat, der in einer Steuer- und Rechenschaltung der Vorrichtung nach Fig.1 abgelegt ist, und in
- Fig.4: ein Diagramm zur Veranschaulichung der relativen Liniendosis beim Schreiben von Kreisringen in einer XY-Ebene in Abhängigkeit des Winkels zu einer der Koordinaten X oder Y.

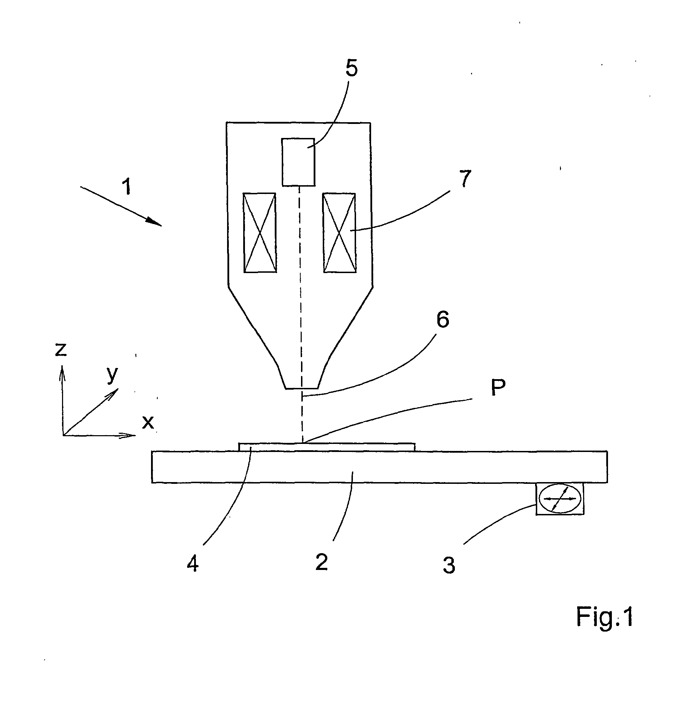

Das Ausführungsbeispiel zeigt in Fig.1 eine Vorrichtung 1 zur Elektronenstrahl-Lithographie. Diese umfaßt einen in den Koordinaten X und Y verfahrbaren Tisch 2 zur Halterung eines ebenen Substrats 4, das in der XY-Ebene aufgespannt wird. Das Substrat 4 besteht aus einem strahlungsempfindlichen Material oder weist zumindest eine Beschichtung aus einem solchen Material auf.

Dem Tisch 2 ist eine Zustelleinrichtung 3 beigeordnet. Mittels der Zustelleinrichtung 3 ist der Tisch sowohl in der X-Koordinate wie auch in der Y-Koordinate schrittweise verfahrbar. Die kleinsten einzelnen Zustelleinheiten in den Richtungen der beiden Koordinaten X und Y, d.h. die Einzelinkremente der Zustelleinrichtung 3 liegen für jede Koordinate X und Y in der Größenordnung von 1 nm bis 10nm, wobei die Zustellgeschwindigkeit etwa 1 mm pro Sekunde beträgt. Beispielsweise wird für beide Koordinaten eine Einzelinkrementweite von 2,5nm verwendet.

Die Vorrichtung zur Elektronenstrahl-Lithographie umfaßt weiterhin eine Elektronenstrahlquelle 5, die einen gebündelten Elektronenstrahl 6 mit konstanter Strahlungsdichte in Richtung auf den Tisch 2 bzw. das Substrat 4 richtet. Der Elektronenstrahl 6 wirkt in Richtung der Koordinate Z senkrecht zu der XY-Ebene auf das Substrat 4 ein. Als Elektronenstrahlquelle 5 wird hier vorzugsweise eine thermische Feldemissionskathode verwendet, die sich durch eine hohe Konstanz der Strahlungsdichte im Elektronenstrahl 6 auszeichnet.

Der Elektronenstrahlquelle 5 ist eine elektromagnetische Ablenkeinrichtung 7 nachgeschaltet, mit der der Auftreffort des Elektronenstrahls 6 an der Oberfläche des Substrats 4 positioniert werden kann. Die Ablenkeinrichtung 7 erlaubt dabei eine Ablenkung des Elektronenstrahls 6 sowohl in Richtung der X-Koordinate als auch in Richtung der Y-Koordinate, wobei die Ansteuerung sowohl analog als auch digital, beispielsweise mit einer 16-Bit-Auflösung, durchgeführt werden kann. In Fig.1 ist der Elektronenstrahl 6 in seiner nicht-ausgelenkten Ausrichtung senkrecht zu der Oberfläche des Substrates 4 bzw. des Tisches 2 dargestellt.

Zum Schreiben eines Linienzuges auf die Oberfläche des Substrates 4 wird der Tisch 2 entsprechend einer vorgegebenen Bahnkurve unter dem in erster Annäherung stationären Elektronenstrahl 6 hindurch bewegt. Etwaige Abweichungen der realen Position des Tisches 2 von einer vorgegebenen Position werden gemessen, beispielsweise mit einem Laserinterferometer, und über eine entsprechende Ablenkung des Elektronenstrahls 6 dynamisch ausgeglichen. Die Auslenkung des Elektronenstrahls 6 liegt hier in der Größenordnung von maximal etwa 20 µm.

Weiterhin ist eine Steuer- und Rechenschaltung vorgesehen, über die ein an dem Substrat 4 auszubildender Linienzug zunächst definiert und anschließend in Zustellbefehle für die Zustelleinrichtung 3 und Vorgaben für den Energieeintrag in das Substrat 4 umgesetzt wird. Der gewünschte Linienzug kann durch eine Vielzahl von kleinen Einzelschritten oder auch von Kurvenstützpunkten in kartesischen Koordinaten definiert werden. Bei einer hohen Auflösung des Linienzuges im Nanometerbereich ergibt sich dadurch allerdings eine sehr große Datenmenge mit hohem Verarbeitungsaufwand. Die Geschwindigkeit beim Schreiben des Linienzuges auf das Substrat 4 ist dann bei gekrümmten Linienzügen verhältnismäßig gering.

Im vorliegenden Fall wird daher der Linienzug bevorzugt durch Bezier-Kurvenabschnitte angenähert. Aus den wenigen Kenngrößen der Bezier-Kurvenabschnitte läßt sich dann die an dem Tisch 2 einzustellende Sollposition entsprechend der Schrittweite der Zustelleinrichtung 3 Schritt für Schritt berechnen. Hiermit läßt sich der Datenumfang insbesondere für gekrümmte Linienzüge erheblich reduzieren und die Arbeitsgeschwindigkeit beim Schreiben des Linienzuges steigern. Ein geeigneter Algorithmus zur Berechnung der Einzelschritte aus den Bezier-Kurvenabschnitten ist in der DE 42 44 462 A1 offenbart und muß demzufolge hier nicht näher erläutert werden.

Für eine besonders hohe Auflösung und enge Approximation bei einem in Bezier-Kenngrößen definierten Linienzug werden vorzugsweise die kleinstmöglichen Einzelschritte der Zustelleinrichtung 3 verwendet. Wie bereits oben erläutert, ist diese schrittweise in der X-Koordinate sowie in der Y-Koordinate bewegbar. Damit ergeben sich als kleinstmögliche Einzelschritte zunächst Tischverschiebungen, bei denen ein Einzelinkrement in einer Koordinatenrichtung ausgeführt wird. Bei zwei Koordinaten X und Y existieren damit vier verschiedene Möglichkeiten.

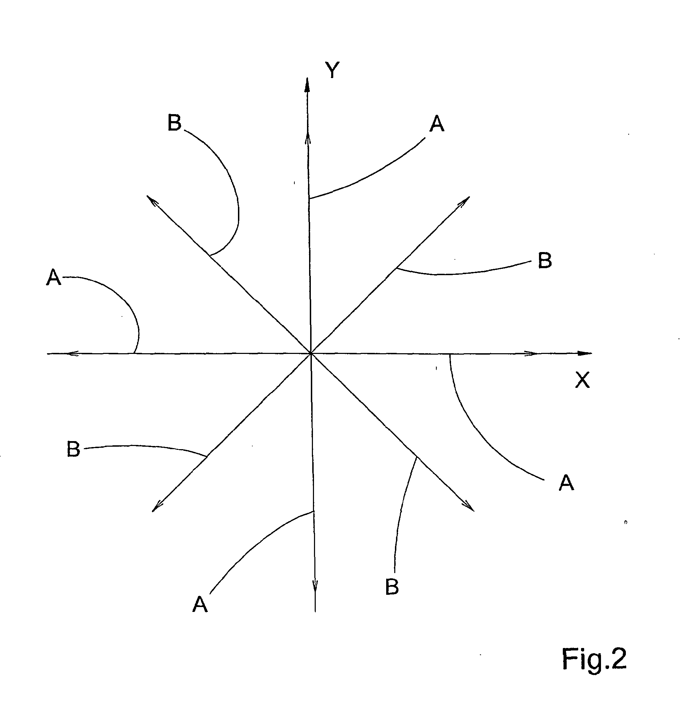

Weiterhin ist es möglich eine Verschiebung gleichzeitig um ein Einzelinkrement in beiden Koordinaten X und Y vorzunehmen, woraus vier weitere, diagonale Einzelschritte resultieren. Die bei dieser Vorgehensweise insgesamt acht möglichen Richtungen der Einzelschritte sind in Fig.2 dargestellt. Unter der Voraussetzung, daß die Einzelinkremente in der X- und Y-Koordinate gleich groß sind, weisen die diagonalen Einzelschritte eine um den Faktor √2 größere Weglänge auf als die achsparallelen Einzelschritte.

Die in Fig.2 dargestellten Richtungen der Einzelschritte bilden die hier verwendeten Grundelemente zur Approximation eines Linienzuges. Sie lassen sich entsprechend der Weglänge der Einzelschritte in zwei Kategorien einteilen, wobei hier die kürzeren, d.h. achsparallelen Einzelschritte einer Kategorie A und die diagonalen Einzelschritte einer Kategorie B zugeordnet werden.

Prinzipiell ist es jedoch möglich, auch weitere Typen von Einzelschritten zu definieren, beispielsweise indem ein solcher Schritt durch mehrere Einzelinkremente in einer oder beiden Koordinatenrichtungen definiert wird. Die Kategorisierung der Schritte erfolgt dann wiederum entsprechend ihrer theoretischen Weglänge. Auch können in den beiden Koordinaten X und Y Einzelinkremente mit unterschiedlicher Länge verwendet werden.

Beim Schreiben eines Linienzuges auf das Substrat 4 werden aus den Bezier-Kenngrößen fortlaufend online vom Tisch 2 auszuführende Einzelschritte berechnet, welche über die Positioniereinrichtung 3 zugestellt werden, so daß sich eine quasi kontinuierliche Tischbewegung ergibt. Für einen soeben berechneten Einzelschritt wird ermittelt, ob dieser der Kategorie A oder der Kategorie B angehört. Je nach Zugehörigkeit wird dem betreffenden Einzelschritt ein Korrekturfaktor zugeordnet, wobei die Korrekturfaktoren jeweils der kürzesten Weglänge der Einzelschritte proportional sind. In dem hier beschriebenen Ausführungsbeispiel erfolgt eine Normierung auf die Einzelschritte der Kategorie A, denen ein Korrekturfaktor von 1 zugeordnet wird, wohingegen den Diagonal-Einzelschritten der Kategorie B der Korrekturfaktor √2 zugeordnet wird.

Die ermittelten Korrekturwerte werden in einem Zwischenspeicher in Form eines Shifters abgelegt, der eine fest vorgegebene Anzahl von Korrekturwerten zwischenspeichern kann. Mit dem Abspeichern eines neuen Korrekturwertes wird der jeweils älteste, abgespeicherte Wert aus dem Zwischenspeicher entfernt. Beispielsweise werden so stets die letzten acht Korrekturfaktoren bereit gehalten.

Mittels dieser Korrekturfaktoren kann annäherungsweise die aktuelle Bahnneigung des Linienzuges berücksichtigt werden. Vorliegend wird hierzu über die in dem Zwischenspeicher abgelegten Korrekturfaktoren der Mittelwert gebildet, der als mittlerer Korrekturfaktor Kₙ eine genauere Information über die Neigung der Bahnkurve gibt. Zur Bestimmung des mittleren Korrekturfaktors Kₙ wird festgestellt, wie viele der letzten acht Einzelschritte auf die Kategorie A und wie viele auf die Kategorie B entfallen. Den hierbei neun möglichen Kombinationen ist jeweils ein mittlerer Korrekturfaktor Kₙ zugeordnet, so daß sich folgende Beziehung ergibt:

| n | Anzahl der | Anzahl der | mittlerer |
|---|---|---|---|
| | Einzelschritte in | Einzelschritte in | Korrekturfaktor |
| | Kategorie A | Kategorie B | Kₙ |
| 1 | 8 | 0 | 1,000 |
| | | | |
| 2 | 7 | 1 | 1,008 |
| | | | |
| 3 | 6 | 2 | 1,031 |
| | | | |
| 4 | 5 | 3 | 1.068 |
| | | | |
| 5 | 4 | 4 | 1.118 |
| | | | |
| 6 | 3 | 5 | 1.179 |
| | | | |
| 7 | 2 | 6 | 1,250 |
| | | | |
| 8 | 1 | 7 | 1,329 |
| | | | |
| 9 | 0 | 8 | √2 |

Der zu einem Einzelschritt errechnete mittlere Korrekturfaktor Kₙ wird zur Bestimmung des Energieeintrages in das Substrat 4 nach dem betreffenden Einzelschritt verwendet, so daß der Energieeintrag in das Substrat 4 proportional zu dem Korrekturfaktor Kₙ und damit entsprechend der aktuellen Bahnneigung des Linienzuges erfolgt.

Bei der Verwendung einer thermischen Feldemissionskathode als Elektronenstrahlquelle 5 ist es aus bereits dargelegten Gründen wenig sinnvoll, die Strahlungsleistung der Kathode zu verändern. Der Energieeintrag, d.h., die an dem Auftreffort P des Elektronenstrahls 6 in das Substrat 4 eingebrachte Energiedosis, läßt sich jedoch über die Einwirkdauer des Elektronenstrahls 6 auf den Auftreffort P beeinflussen. Hierzu wird in einfacher Weise die Verweilzeit des Tisches 2 nach einem Einzelschritt proportional zu dem Korrekturfaktor Kₙ eingestellt.

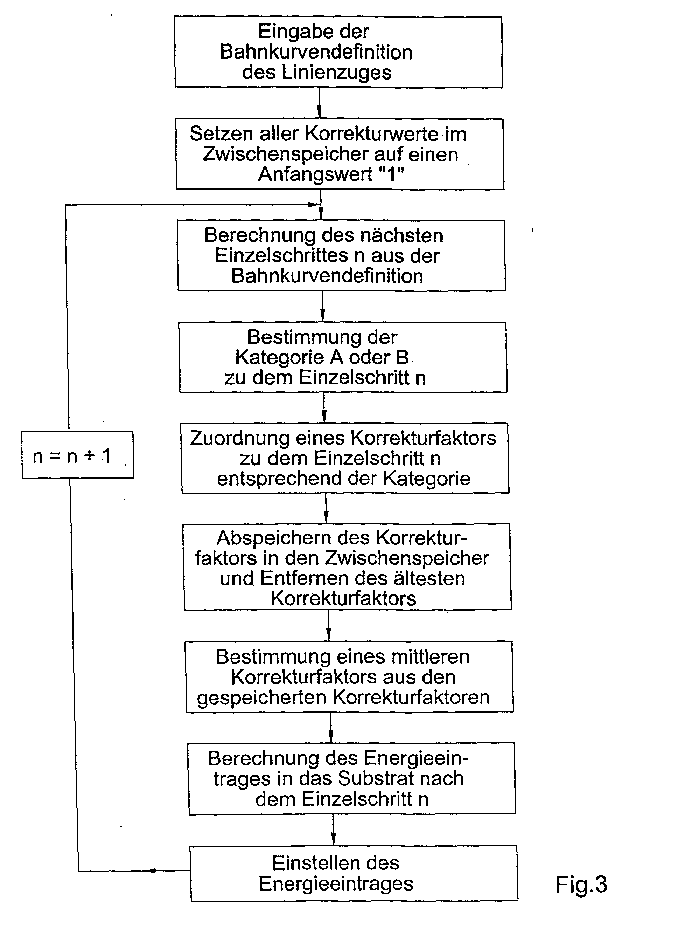

Parallel hierzu kann bereits die Berechnung des nachfolgenden Einzelschrittes vorgenommen werden, die wie in der vorstehend beschriebenen Art und Weise erfolgt. Ein entsprechender Ablaufplan ist in Figur 3 dargestellt.

In einer Ausführungsvariante der Erfindung erfolgt die Einstellung des Energieeintrages über die Veränderung der nach einem Einzelschritt an dem Auftreffort P einwirkenden Strahlungsleistung. Prinzipiell wäre es denkbar, hierzu die Änderung der von der Strahlungsquelle 5 abgegebene Strahlungsleistung unmittelbar an dieser vorzunehmen. Bei der Verwendung einer thermischen Feldemissionskathode ist dies jedoch nicht zweckmäßig, da diese nur sehr langsam auf eine Veränderung ihrer Einstellparameter reagiert.

Vielmehr wird in diesem Fall der gleichbleibende, von der Feldemissionskathode abgegebene Elektronenstrahl 6 durch eine nachgeschaltete Schwächungseinrichtung, beispielsweise eine Luftspule, vermindert. Diese wird in Abhängigkeit des mittleren Korrekturfaktors Kₙ derart eingestellt, daß die Strahlungsleistung des Elektronenstrahls 6 nach seiner Schwächung proportional zu dem mittleren Korrekturfaktor Kₙ ist, der für den betreffenden Einzelschritt ermittelt wurde.

Durch die in beiden Fällen erfolgende Berücksichtigung der "Vorgeschichte" eines Einzelschrittes bei der Bestimmung der nach diesem Einzelschritt in das Substrat 4 eingebrachten Dosis werden die eingangs erläuterten Über-Bestrahlungseffekte bis auf einen geringfügigen, in der Praxis zu vernachlässigenden Restfehler in der Größenordnung von etwa 0,5 % vermindert.

Allerdings stehen am Beginn eines Kurvenzuges keine älteren Informationen über vorhergehende Einzelschritte zur Verfügung. Dem wird dadurch abgeholfen, daß in dem Zwischenspeicher für die nichtexistierenden Einzelschritte ein Korrekturwert willkürlich gesetzt wird. Der hieraus resultierende Anfangsfehler ist jedoch praktisch ohne Einfluß. Bei der Berücksichtigung von beispielsweise acht vorhergehenden Einzelschritten wird dann ab dem neunten Einzelschritt eine vollständige Berücksichtigung des bisherigen Verlaufs des Linienzuges erfolgen. Die nicht bekannten Einzelschritte werden vorläufig der Kategorie A zugeordnet und erhalten einen Korrekturfaktor von 1.

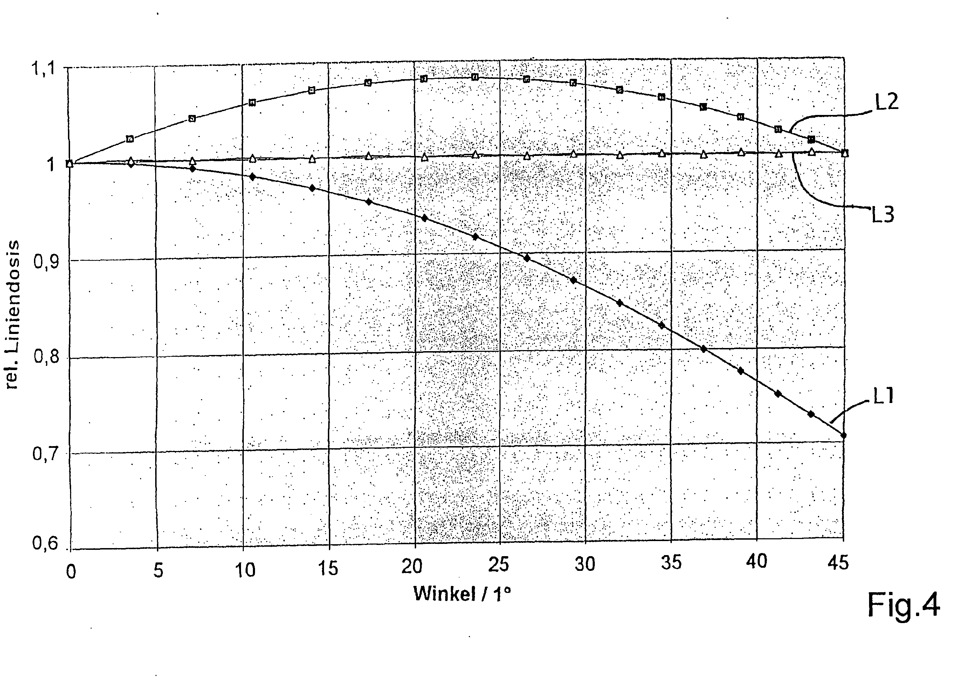

Fig.4 zeigt nun einen Vergleich der relativen Liniendosis beim Schreiben von Kreislinien in Abhängigkeit des Winkels zu einer Koordinatenachse. Ein Winkel von 0° entspricht dabei einem achsparallelen Bahnabschnitt, wohingegen ein Winkel von 45° für einen Bahnabschnitt parallel zu der ersten Winkelhalbierenden steht.

Wird ein Kreisring durch Einzelschritte der oben erläuterten Kategorien A und B approximiert und nach jedem Einzelschritt ein Energieeintrag gleicher Größe vorgenommen, so wird lediglich für achsparallele Abschnitte eines Linienzuges mit der korrekten Liniendosis geschrieben. Für alle anderen, geneigten Bahnabschnitte ist die Dosis dann jedoch zu gering, wie dies aus L1 anschaulich hervorgeht.

Wird hingegen nach Diagonalschritten der Kategorie B im Unterschied zu achsparallelen Einzelschritten der Kategorie A der Energieeintrag um den Faktor √2 erhöht, so ergibt sich für achsparallele Abschnitte des Linienzuges sowie auch für Abschnitte unter einem Winkel von 45° die korrekte Liniendosis. Für dazwischenliegende Bahnneigungen ist der Energieeintrag jedoch zu hoch, so daß sich dort eine unerwünschte Breitenänderung des Linienzuges einstellt, die von der Bahnneigung abhängig ist. Dies ist in Fig.4 anhand der Linie L2 veranschaulicht.

Durch die Berücksichtigung vorhergehender Einzelschritte bei der Bestimmung des Energieeintrages in das Substrat ergibt bei Berücksichtigung von acht vorhergehenden Einzelschritten die Kurve L3, die eine nur noch geringfügige und in der Praxis vernachlässigbare Abhängigkeit der Liniendosis von dem Bahnneigungswinkel des Linienzuges zeigt.

### Bezugszeichenliste

- 1: Vorrichtung
- 2: Tisch
- 3: Zustelleinrichtung
- 4: Substrat
- 5: Strahlungsquelle
- 6: Elektronenstrahl
- 7: Ablenkeinrichtung
- X, Y, Z: Koordinate
- Kₙ: mittlerer Korrekturfaktor

## Patentansprüche

1. Verfahren zur Ausbildung eines gekrümmten Linienzuges auf einem mit einem strahlungsempfindlichen Resist beschichteten Substrat (4) mit Hilfe eines Elektronenstrahls (6), **gekennzeichnet durch** folgende Schritte:
- Richten des Elektronenstrahls (6) in Richtung der Koordinate Z eines kartesischen Rasters auf die beschichtete Substratoberfläche
- Verschieben des Substrats (4) schrittweise in Richtung der Koordinaten X und/oder Y des kartesischen Rasters, während der Elektronenstrahl (6) mit vorgegebener effektiver Dosis auf den Resist einwirkt, und
- Bestimmen der vorzugebenden effektiven Dosis mittels einer mit einem Zwischenspeicher verbundenen Rechenschaltung nach jeweils einem Einzelschritt in Abhängigkeit von dem aus mehreren vorhergehenden Einzelschritten ermittelten Verlauf des Linienzuges **durch** (a) Festlegen von Substratverschiebungs-Kategorien für die Einzelschritte, die sich nach der Schrittweite eines Einzelinkrements unterscheiden, (b) Zuordnung von Korrekturfaktoren zu den Substratverschiebungs-Kategorien, die proportional zu der Schrittweite eines Einzelinkrements sind und (c) Bildung eines mittleren Korrekturfaktors aus den im Zwischenspeicher abgelegten Korrekturfaktoren für die vorhergehenden Einzelschritte.

2. Verfahren nach Anspruch 1, **dadurch gekennzeichnet, daß** der mittlere Korrekturfaktor aus acht vorhergehenden Einzelschritten wie folgt bestimmt wird:
| n | Anzahl der Einzelschritte in Kategorie A | Anzahl der Einzelschritte in Kategorie B | mittlerer Korrekturfaktor Kₙ |
|---|---|---|---|
| 1 | 8 | 0 | 1,000 |
| | | | |
| 2 | 7 | 1 | 1,008 |
| | | | |
| 3 | 6 | 2 | 1,031 |
| | | | |
| 4 | 5 | 3 | 1.068 |
| | | | |
| 5 | 4 | 4 | 1.118 |
| | | | |
| 6 | 3 | 5 | 1.179 |
| | | | |
| 7 | 2 | 6 | 1,250 |
| | | | |
| 8 | 1 | 7 | 1, 329 |
| | | | |
| 9 | 0 | 8 | √2 |
wobei n ein Zählindex ist und wobei die Einzelschritte in Abhängigkeit von der Verschiebung des Substrates (4) den Kategorien A und B wie folgt zugeordnet werden:
- Kategorie A: achsparallele Einzelschritte mit der Schrittweite eines Einzelinkrements in Richtung der Koordinate X oder in Richtung der Koordinate in Y
- Kategorie B: diagonale Einzelschritte mit der Schrittweite eines Einzelinkrements in Richtung der Koordinate X und in Richtung der Koordinate Y

3. Verfahren nach Anspruch 2, **dadurch gekennzeichnet, daß** die effektive Dosis von Einzelschritt zu Einzelschritt proportional zu dem mittleren Korrekturfaktor geändert oder neu vorgegeben wird.

4. Verfahren nach Anspruch 3, **dadurch gekennzeichnet, daß** bei gleichbleibender Strahlungsleistung die Einwirkdauer des Elektronenstrahls (6) für jeden Einzelschritt proportional zu dem Korrekturfaktor geändert oder neu vorgegeben wird.

5. Verfahren nach Anspruch 3, **dadurch gekennzeichnet, daß** bei gleichbleibender Einwirkdauer des Elektronenstrahls (6) die Strahlungsleistung für jeden Einzelschritt proportional zu dem Korrekturfaktor geändert oder neu vorgegeben wird.

6. Elektronenstrahllithographische Vorrichtung zur Ausbildung eines gekrümmten Linienzuges auf einem mit einem strahlungsempfindlichen Resist beschichteten Substrat (4), enthaltend
- eine Strahlungsquelle (5) für einen in der Koordinate Z eines kartesischen Rasters ausgerichteten Elektronenstrahl (6),
- eine in Einzelschritten in einer XY-Ebene des kartesischen Rasters verschiebbare Zustelleinrichtung (3) zur Erzeugung einer Relativbewegung zwischen dem Substrat (4) und dem Elektronenstrahl (6),
- einen Zwischenspeicher, der zur Speicherung für eine vorgegebene Anzahl von mehreren, Substratverschiebungs-Kategorien der Einzelschritte zugeordneten Korrekturwerten ausgebildet ist, wobei die Korrekturwerte proportional zur Schrittweite von Einzelinkrementen sind, nach der sich die Substratverschiebungs-Kategorien unterscheiden, und
- eine mit dem Zwischenspeicher und mit einer Ansteuerschaltung für die Strahlungsquelle (5) verbundene Rechenschaltung zur Ermittlung eines mittleren Korrekturwertes aus den in dem Zwischenspeicher gespeicherten Korrekturwerten für die vorhergehenden Einzelschritte und zur Ermittlung einer jeweils für einen Einzelschritt in Abhängigkeit von dem aus mehreren vorhergehenden Einzelschritten ermittelten Verlauf des Linienzuges proportional zu dem mittleren Korrekturwert vorzugebenden effektiven Dosis, mit der der Elektronenstrahl (6) auf den Resist einwirkt.

## Claims

1. A method for forming, with the aid of an electron beam (6), a curved polyline on a substrate (4) coated with a radiation-sensitive resist, said method being **characterized by** the following steps:
- directing the electron beam (6) onto the coated substrate surface in the direction of the Z coordinate of a Cartesian grid,
- displacing the substrate (4) stepwise in the direction of the X and/or Y coordinates of the Cartesian grid, while the electron beam (6) acts at a defined effective dosage on the resist, and
- determining after each individual step, by means of a calculation circuit connected to a temporary storage and as a function of the shape of the polyline determined from several preceding individual steps, the effective dosage to be defined, by (a) defining substrate displacement categories for the individual steps which differ by the step distance of an individual increment, (b) allocating correction factors to the substrate displacement categories, said correction factors being in proportion to the step distance of an individual increment, and (c) forming an average correction factor from the correction factors, stored in the temporary storage, for the preceding individual steps.

2. The method according to claim 1, **characterized in that** the average correction factor is determined as follows from eight preceding individual steps:
| n | Number of individual steps in category A | Number of individual steps in category B | Average correction factor Kₙ |
|---|---|---|---|
| 1 | 8 | 0 | 1.000 |
| 2 | 7 | 1 | 1.008 |
| 3 | 6 | 2 | 1.031 |
| 4 | 5 | 3 | 1.068 |
| 5 | 4 | 4 | 1.118 |
| 6 | 3 | 5 | 1.179 |
| 7 | 2 | 6 | 1.250 |
| 8 | 1 | 7 | 1.329 |
| 9 | 0 | 8 | 2 |
wherein n is a counting index and wherein the individual steps are allocated as follows to the categories A and B as a function of the displacement of the substrate (4):
- Category A: paraxial individual steps with the step distance of one individual increment each in the direction of the X coordinate or in the direction of the Y coordinate;
- Category B: diagonal individual steps with the step distance of one individual increment each in the direction of the X coordinate and in the direction of the Y coordinate.

3. The method according to claim 2, **characterized in that** the effective dosage is modified or redefined from one individual step to another in proportion to the average correction factor.

4. The method according to claim 3, **characterized in that**, with a constant radiation output, the application duration of the electron beam (6) is modified or redefined for each individual step in proportion to the correction factor.

5. The method according to claim 3, **characterized in that**, with a constant application duration for the electron beam (6), the radiation output is modified or redefined for each individual step in proportion to the correction factor.

6. An electron beam lithography apparatus for forming a curved polyline on a substrate (4) coated with a radiation-sensitive resist, said apparatus comprising
- a radiation source (5) for an electron beam (6) oriented in the Z coordinate of a Cartesian grid;
- a feed device (3) displaceable in individual steps in an XY plane of the Cartesian grid in order to generate a relative motion between the substrate (4) and the electron beam (6);
- a temporary storage, which is provided for storing a defined number of several correction values allocated to substrate displacement categories of the individual steps, the correction values being in proportion to the step distance of individual increments by which the substrate displacement categories differ, and
- a calculation circuit, which is connected to the temporary storage and to an activation circuit for the radiation source (5), for determining an average correction value from the correction values for the preceding individual steps, which values are stored in the temporary storage, and for determining an effective dosage with which the electron beam (6) acts on the resist, said dosage being defined for each individual step as a function of the shape of the polyline determined from several preceding individual steps.

## Revendications

1. Procédé destiné à constituer, à l'aide d'un faisceau électronique (6), une polyligne courbée sur un substrat (4) enduit d'un résiste sensible au rayonnement, ledit procédé étant **caractérisé par** les étapes
- de diriger le faisceau électronique (6) sur la surface enduite du substrat dans la direction de la coordonnée Z d'une grille cartésienne,
- de déplacer le substrat (4) pas à pas dans la direction des coordonnées X et/ou Y de la grille cartésienne durant l'application du faisceau électronique (6) au résiste à une dose définie, et
- de déterminer après chaque pas individuel, au moyen d'un circuit de calcul relié à une mémoire temporaire et en fonction le tracé de la polyligne déterminé à partir de plusieurs pas individuels précédents, la dose effective à définir, en (a) définissant des catégories de déplacement du substrat pour les pas individuels qui se distinguent d'un pas de progression correspondant à un seul incrément individuel, (b) en affectant aux catégories de déplacement du substrat des facteurs de correction qui sont proportionnels au pas de progression d'un incrément individuel, et (c) en constituant un facteur moyen de correction à partir des facteurs de correction, mémorisés dans la mémoire temporaire, pour les pas individuels précédents.

2. Procédé selon la revendication 1, **caractérisé en ce que** le facteur moyen de correction est déterminé de la manière suivante, à partir de huit pas individuels précédents:
| n | Nombre de pas individuels dans la catégorie A | Nombre de pas individuels dans la catégorie B | Facteur moyen de correction |
|---|---|---|---|
| 1 | 8 | 0 | Kₙ 1,000 |
| 2 | 7 | 1 | 1,008 |
| 3 | 6 | 2 | 1,031 |
| 4 | 5 | 3 | 1,068 |
| 5 | 4 | 4 | 1,118 |
| 6 | 3 | 5 | 1,179 |
| 7 | 2 | 6 | 1,250 |
| 8 | 1 | 7 | 1,329 |
| 9 | 0 | 8 | 2 |
où n est un indice de comptage et les pas individuels sont affectés de la manière suivante aux catégories A et B selon le déplacement du substrat (4):
- Catégorie A: des pas individuels paraxiaux présentant un pas de progression d'un seul incrément individuel dans la direction de la coordonnée X ou dans la direction de la coordonnée Y;
- Catégorie B:des pas individuels diagonaux présentant un pas de progression d'un seul incrément dans la direction de la coordonnée X et dans la direction de la coordonnée Y.

3. Procédé selon la revendication 2, **caractérisé en ce que** la dose effective est modifiée ou redéfinie d'un pas individuel à l'autre de manière proportionnelle au facteur moyen de correction.

4. Procédé selon la revendication 3, **caractérisé en ce que**, la puissance de rayonnement restant constante, la durée d'application du faisceau électronique (6) est modifiée ou redéfinie pour chaque pas individuel de manière proportionnelle au facteur de correction.

5. Procédé selon la revendication 3, **caractérisé en ce que**, la durée d'application du faisceau électronique (6) restant constante, la puissance de rayonnement est modifiée ou redéfinie pour chaque pas individuel de manière proportionnelle au facteur de correction.

6. Dispositif de lithographie par faisceau électronique destiné à constituer une polyligne courbée sur un substrat (4) enduit d'un résiste sensible au rayonnement, ledit dispositif comprenant
- une source de rayonnement (5) pour un faisceau électronique (6) orienté selon la coordonnée Z d'une grille cartésienne;
- un dispositif d'amenage (3) déplaçable dans des pas individuels selon un plan XY de la grille cartésienne afin d'engendrer un mouvement relatif entre le substrat (4) et le faisceau électronique (6);
- une mémoire temporaire qui sert à mémoriser un nombre défini de plusieurs valeurs de correction affectées à des catégories de déplacement du substrat des pas individuels, ces valeurs de correction étant proportionnelles au pas de progression d'incréments individuels duquel les catégories de déplacement du substrat se distinguent, et
- un circuit de calcul, relié à la mémoire temporaire et à un circuit d'activation pour la source de rayonnement (5), afin de déterminer une valeur moyenne de correction à partir des valeurs de correction pour les pas individuels précédents, ces valeurs étant mémorisées dans la mémoire temporaire, et afin de déterminer une dose effective à laquelle le faisceau électronique (6) est appliqué au résiste, cette dose étant définie pour chaque pas individuel en fonction du tracé de la polyligne déterminé à partir de plusieurs pas individuels précédents.
